# EUROPEAN PATENT APPLICATION

(11) **EP 1 367 873 A1**
(43) Date of publication of application: **03.12.2003**
(21) Application number: 03253329.1
(22) Date of filing: 28.05.2003
(51) Int. Cl.: H05K 3/26

(54) **Process of producing printed circuit boards and the circuit boards formed thereby**

(30) Priority: 28.05.2002 US 383671 P
(71) Applicant: Shipley Co. L.L.C., Marlborough, MA 01752 (US)
(72) Inventor: Lefebvre, Mark, Hudson, New Hampshire 03051 (US); Bayes, Martin W., Hopkinton, Massachusetts 01748 (US); Cook, Lee M., Steelville, Pennsylvania 19310 (US)
(74) Representative: Kent, Venetia Katherine

(57) **Abstract**

Provided for herein is a method of planarizing a printed circuit board substrate including contacting at least a portion of a printed circuit board substrate with a planarizing liquid, a planarizing surface, and an abrasive component that produces a surface texture on the planarized surface, the texture having a roughness less than the smallest wiring feature on the substrate, wherein the planarizing liquid includes a liquid carrier, and optionally components to remove material from the circuit board substrate and wherein the contacting comprises a plurality of contacting motions on the printed circuit board substrate.

## Description

### BACKGROUND

The present invention relates to a method of producing improved printed circuit boards, and the circuit boards formed thereby.

An integrated circuit, also know as an IC, is typically a three-dimensional collection of transistors, capacitors and other components prearranged and packaged as a single unit on a semi-conductor substrate. However, to be useful, an IC must be in contact with the external environment. To provide the necessary electrical connections to and from an IC, or any other electronic component, conductive material, often in the form of copper connectors, is arranged on the surface of a non-conductive, usually polymeric substrate, to which any number of ICs and other components are attached. This collection of conductors arranged on a substrate is collectively referred to as a printed circuit board (PCB) and/or a printed wiring board (PWB), herein collectively referred to as a PCB.

As advances in IC technology continue to allow for more and more circuitry per unit area, so too must the PCB be arranged to connect these circuits in a meaningful way. In fact, it is the PCB and not the IC that converts the microscopic circuitry into a macroscopic arrangement for assembly and use. Methods for improved manufacturing of ICs have been extensively described, in particular methods for improvements in chemical mechanical planarization (CMP) of ICs. See for example: United States Patent No. 6,220,934 to Sharples et al., United States Patent No, 6,234,875 to Pendergrass, Jr., United States Patent No.9,972,792 to IIudson, and United States Patent No. 5,759,427 to Cibulsky et al.

While such methods may appear complementary to PCBs, there exist major differences in the processes required to form a microscopic IC, as compared to forming a macroscopic PCB. Differences between producing an IC and a PCB must take into account the relative size difference between the two, and the selection of the materials from which each are fabricated. While the components and circuitry contained on an IC are arranged and interconnected on the surface of a thin wafer of a highly purified semiconductor substrate, for example silicon, the circuitry and components of a PCB (e.g. transistor, diodes, and resistors) are typically fabricated separately and arranged on the surface of a fiber-reinforced polymeric dielectric material of a circuit board. While an IC is designed for placement on a silicon crystal, a PCB is designed for placement on an amorphous polymer, usually a composite, that has been pressed, extruded, drilled, cut, or otherwise formed into a desired conformation.

An important step in the formation of a PCB is providing a planar surface on both the polymeric substrate as well as the conductive material and circuit lines. Planarization allows control of the height and width of the connectors (e.g., printed circuit lines) on the surface of the circuit board substrate. This task is difficult to accomplish in view of the various irregularities in the printed circuit board substrate such as those described above (e.g., burrs, pigtails from drilling, plating defects, nodules, depressions, and the like), The incorporation of blind vias presents a significant challenge to providing an essentially planar surface, due to the lack of uniformity in the surface directly over the via once it has been filled. Improvements in planarizing PCBs before and after the application of all the conductors, especially when so-called "blind-vias" arc incorporated, into the circuit design would therefore be beneficial.

Effective planarization is particularly important as the size of ICs decrease and the number of connections increase, because the density of connectors (defined herein as the number of separate connectors per unit area) running to and from the IC must also increase.

Planarization of PCBs has been effected by a variety of techniques, including fixed abrasive grinding, electropolishing, and chemo-mechanical polishing. These techniques have been cited in a number of prior art patents (e.g., United States Patent Nos. 6,365,438, 6,319,834, 6,107,186, 6,326,299, 6,291,779, 6,225,031, 6,351,026, 6,165,629, 6,030,693, 5,759,427, 5,753,372, 5,679,444, and 5.424,295). These patents simply disclose the utility of planarization for topography correction and make no mention of the nature of the planarized surface produced. Moreover, they do not disclose the criticality of producing controlled texture in the planarized surface to further improve the final PCB structure.

Another issue that arises in the scaling down of wiring dimensions in PCBs is the control of interfacial bond strength between conductor and insulator and between the wiring metal and photoresists. Variations in size and thickness of the conductive and insulator components give rise to complex thermal stresses during both processing and final use in electronic devices. This is compounded by the number of wiring layers in the PWB and mismatches in thermal expansion coefficient between wiring and insulator. If the bond strength between the wiring metal and insulator is low, these stresses can produce delamination failure in the PWB.

A well-known prior art technique for increasing the effective bond strength between materials is mechanical anchoring by way of roughening. A rough surface leads to a higher interfacial volume, providing increased resistance to delamination. Conventionally, roughening is done subsequently to any planarization step as a separate operation using either free abrasive or fixed abrasive particles The dimensions of abrasive particles typically exceed 10 microns, and produce roughness proportional to their dimensions. For very large wiring features, a roughness of 10-50 micrometers (um) represents a small fraction of the wiring dimension. However, as via dimensions decrease, particularly below 100 um, this level of roughness is a large fraction of the wiring dimension and causes damage to the wiring structure that can lead to loss of electrical contact. It is, therefore desirable to develop alternative texturing processes for such small wiring dimensions that effects improved bond strength while avoiding damage to the wiring itself.

Accordingly, improvements in methods for planarization of PCBs that enable increased density of connectors with improved physical integrity and freedom from damage would be beneficial. These methods are most useful, of course, when they allow increased efficiency (by reducing the number of manufacturing steps) and lower cost.

### STATEMENT OF THE INVENTION

In one aspect of the present invention, there is provided a method of preparing a printed circuit board substrate comprising contacting at least a portion of a surface of said printed circuit board substrate with a planarizing liquid, a planarizing surface, and an abrasive component to produce a surface texture on said printed circuit board surface having a roughness with a cross sectional area less than a cross sectional area of a smallest wiring feature on said printed circuit board surface, wherein said planarizing liquid includes a liquid carrier, optionally a component to remove material from said circuit board substrate, and wherein said contacting comprises a plurality of random contacting motions on said printed circuit board surface.

In another aspect, there is provided a method of preparing a printed circuit board substrate comprising: contacting at least a portion of a surface of said printed circuit board substrate with a planarizing liquid, a planarizing surface, and an abrasive component to produce a surface texture on said printed circuit board surface having a roughness with a cross sectional area less than a cross sectional area of a smallest wiring feature on said printed circuit board surface, wherein said planarizing liquid includes a liquid carrier, optionally a component to remove material from said circuit board substrate, and wherein said planarizing liquid is applied to said printed circuit board substrate, said planarizing surface, or both in discrete increments or continuously over time.

Also provided for is a method of preparing a printed circuit board substrate comprising contacting at least a portion of a first side of said printed circuit board substrate with a first planarizing liquid, a first planarizing surface, and an abrasive component to produce a surface texture on said first side having a roughness with a cross sectional area less than a cross sectional area of a smallest wiring feature on said first side while movably contacting at least a portion of a second side of said printed circuit board substrate located opposite said first side with a second planarizing liquid, a second planarizing surface and an abrasive component to produce a texture on said second side having a roughness with a cross sectional area less than a cross sectional area of a smallest wiring feature on said second side, wherein each of said planarizing liquids includes a liquid carrier and optionally a component to remove material from said each of said sides.

Furthermore, provided for is a method of preparing a printed circuit board substrate comprising contacting at least a portion of a surface of said printed circuit board substrate with a planarizing liquid containing an electrolyte, a planarizing surface, and an abrasive component; applying an electric current to said planarizing surface and said printed circuit board substrate through said liquid electrolyte to produce a surface texture on said printed circuit board surface having a roughness with a cross sectional area less than a cross sectional area of a smallest wiring feature on said printed circuit board surface, wherein said planarizing liquid includes a liquid carrier, optionally a component to remove material from said circuit board substrate.

### DETAILED DESCRIPTION

In the present invention, the substrate for the printed circuit board (hereinafter PCB substrate) is placed in physical contact with a planarizing surface, along with a planarizing liquid, The planarizing surface may be a planar pad, head, and/or cylindrical roller in design and is in motion while a force biased against the PCB substrate holds the planarizing surface in contact with the surface of the PCB substrate. Thus, the structure and composition of the planarization surface is sufficient to contact the PCB substrate so as to remove material necessary for planarization. It is preferred that the planarization leaves unchanged the various other features not intended to be modified. As such, the structure and composition of the planarizing surface are determined by the type and amount of material to be removed from the PCB substrate. For example, the planarizins surface may be a roller in circular motion while in contact with the PCB substrate. Alternatively, the planarization surface may be an essentially horizontal pad in horizontal motion, vertical motion, random motion, defined motions or combinations thereof (i.e., moveably contacting) while in contact with the PCB substrate.

The planarization-surface may include a thermosetting, thermoplastic, and/or elastomeric coating that comes in contact with the PCB substrate, and may also be impregnated with an abrasive in addition, or in substitution for an abrasive disposed in the planarizing liquid, which preferably provides a surface texture to the substrate simultaneously with planarization thereby providing an improved bond strength of materials subsequently laminated to the planarized PCB surface.

One aspect of the present invention includes the simultaneous planarization and texturing of the PCB surface being treated, The texturing function may be provided by incorporation of a suitable abrasive component in the planarizing liquid, the planarization surface, or both in combination, so long as the resulting cross sectional area of the texture roughness, defined herein as being the area of a plane perpendicular to a major axis of the indentation responsible for the roughness characteristic, also expressed as "rms" roughness is not more than the cross sectional area of the smallest cross-section of wiring features in the PCB being processed. Preferably, the resulting cross sectional area of a texture imparted by the texturing function is 1 to 10 % by area of the cross sectional area of the smallest wiring element present on the PCB being processed. This allows the greatest degree of flexibility in the process, to accommodate a wide variety of materials and process sequences, while producing a textured planar surface capable of yielding improved bond strength to other materials joined to it after the simultaneous planarization and texturing. The density and depth of the texturing produced in the current invention can be readily adjusted by varying the size, shape, spacing, and type of abrasive particle employed. The limitation to the magnitude of the resulting texture roughness is specifically selected in order to prevent damage to the wiring cross-section. These, and other, details are made more clear below.

A suitable planarizing liquid for use herein is capable of assisting the planarizing surface to remove an amount of material from the PCB substrate to form an essentially planar surface on the intended areas while, optionally, providing an appropriate surface texture to the substrate simultaneously with planarization in order to improve the bond strength of materials subsequently laminated to the planarized PCB surface.

The composition of the planarizing liquid can be adjusted to provide the required amount of removal and texturing for the specific PCB component materials being planarized. These PCB component materials arc typically either metal conductors (e.g., copper, gold, aluminum, and combinations comprising at least one of the foregoing metals) or insulators (e.g., SiO₂, Al₂O₃, or polymers such as epoxy, polyimide, and the like) but may also include optical components such as waveguides, optical interconnects and the like (c.g. glass or polymers including organic polymers and inorganic/organic polymers such as poly (methyl methacrylate) and organopolysilica materials). Depending on whether only a portion of the PCB substrate or a PCB component needs to be processed or whether the entire excess portion of the PCB substrate or a PCB component needs to be processed, the planarization process can be designed to stop when a surface is reached having the desired degree of planarization. In the alternative, the planarization process can stop when the underlying layer is reached, just before the underlying layer, or component is reached, or at a predetermined layer thickness level.

Different planarizing liquid compositions and/or formulations may be required for planarization, removal of particulates, or texturing of different materials. The planarization liquid contains a carrier, preferably water. For planarization of metal PCB substrate layers, exemplary planarization liquids also contain a corrosion inhibitor, an organic polymer viscosity adjusting agent, an oxidizing agent, and a plurality of fine particles having a size that produces a surface roughness, preferably at least 10 times smaller than the texture roughness produced by the texturing abrasive. Moreover, the planarization liquid typically has a solution pH effective to cause corrosion of the metal to be planarized in the absence of the other constituents, Typically, however, the planarization liquid does not cause static corrosion of the metal to be planarized. This absence of static corrosion is thought to be critical to the successful planarization of so called "fine pitch" metal wiring, unlike United States Patent No. 5,759,427, directed to the efficacy of using an etchant to planarize. A possible reason is that for wiring dimensions below 100 µm, static corrosion during planarization can produce recessing of exposed wiring cross-sections, which degrades planarity because the etchants preferentially etch grain boundaries. This can lead to so called "grain pull-out" or crevices that degrade the integrity of electrical contacts to subsequent wiring layers in the PCB.

A suitable corrosion inhibiting agent retards or prevents static corrosion in areas of the PCB surface not in contact with the planarizing surface. A variety of inhibitors may be used, depending on the metal being planarized, the solution pH, and interactions with other component materials. For example, when copper is being used, triazoles such as hydroxybenzotriazole, mercaptobenzotriazole and benzotriazole (BTA), imidazoles, tetrazoles and related compounds are suitable.

A suitable viscosity-adjusting agent allows adjustment of the lubrication characteristics of the planarization liquid, and, more specifically, permits control of drag forces and control of the roughness of the texture on the planarized PCB surface. During planarization, the contact force on the PCB via the planarizing surface will be a function of the applied load and the viscosity of the planarizing liquid. Part of the applied load is borne by the liquid itself, the remainder being transmitted to the PCB substrate through direct contact with the texturing abrasive particles. The roughness texture produced by this loaded contact is proportional to the contact radius of the texturing abrasive and the applied load. Thus, the roughness texture can be fine-tuned for a given abrasive by adjusting the viscosity of the planarizing liquid (e.g., increase the viscosity to decrease roughness and decrease the viscosity to increase roughness). This allows flexible process adjustment. Examples of suitable viscosity adjusting agents are dilute solutions of poly(methylmethacrylate), polyacrylic acid, polyacrylamide carboxymethyl cellulose, pectin, guar gum, and combinations comprising at least one of the foregoing.

A suitable oxidizing agent increases the rate of removal during planarization. Examples of suitable oxidizing agents include, but are not limited to hydrogen peroxide, ozone, oxygen, nitrate salts, perchloric acid and perchlorate salts, periodic acid, periodate salts, persulphate salts, and combinations comprising at least one of the foregoing.

The optional fine particles may increase the removal rate of the PCB without affecting the roughness of the texturing abrasive. Such fine particles, typical of those used in polishing slurries, are sufficiently small to prevent scratching or fracture and, by themselves, produce roughness on the order of 0.001 µm or less. Examples of such fine polishing abrasives include colloidal SiO₂, Al₂O₃, TiO₂, CeO₂, diamond, Fe₂O₃, and combinations comprising at least one of the foregoing. The ranges of the median particle distribution suitable for use in the present invention are 0.02 to 0.5 µm.

For planarization of a dielectric layer in PCBs, the planarizing liquid also preferably contains a corrosion inhibitor, an organic polymer viscosity adjusting agent, an optional oxidizing agent, and an optional fine particle of a size that produces a surface roughness, preferably at least 10 times smaller than the roughness produced by the texturing abrasive.

The particular components in the planarizing liquid and relative quantities thereof arc readily determined by one of ordinary skill in the art using the above guidelines without undue experimentation, and will depend on factors such as the composition of the PCB substrate, the composition of the metal conductors, the amount to be removed, the particular size and shape of the features, and the like. In general, most PCB substrates exhibit a lower sensitivity to pH, as most dielectric materials do not exhibit strong corrosion behavior (e.g., arc not easily affected by the corrosive materials used in PWB manufacture). The most significant reason for adjusting pH in a dielectric planarization step is to prevent or minimize removal of exposed metal features, Thus, for example, while planarization of copper layers is most effective at pH 2.5 to 3.5, planarization of dielectric layers having exposed copper wiring components is more suitably performed at a higher pH, particularly pH 5 to 8, where removal of the copper is minimal.

The function of the texturing abrasive is to produce a specific range of roughness (texture) on the PCB surface during planarization to enhance the adhesion strength to layers of other materials deposited after planarization. The texturing abrasive may be incorporated into the planarizing liquid, the planarization surface, or both in combination. Preferably, the resulting texture roughness is not more than 10% of the smallest cross-section of a wiring feature in the PCB being processed. Thus, for PCBs having wiring dimensions of 50 to 125 µm, preferably the upper limit to the roughness produced by the texturing abrasive would be 5 to 12.5 µm.

The effective roughness produced by the texturing abrasive will be affected by variables such as the applied load, the planarization liquid viscosity and the diameter of the texturing abrasive particles used, Because of the interaction of these variables, simple rules for determining a specific range arc difficult to present. However, as a general rule, the roughness follows the expression R=0.75D*(P/2KE)^{0.66}, where D is the texturing abrasive diameter, P is the applied load, K is the particle concentration, and E is the Young's Modulus of the texturing abrasive particle. A general rule of thumb is that the roughness will be about 25% of the abrasive diameter for most practical conditions. Thus a preferred general guideline for the upper size limit of the texturing abrasive for PCBs with wiring dimensions of 50 to 100 µm will be 12 to 25 µm. In this instance, a lower limit for texturing abrasives is preferably 5 µm, which is 10 times the maximum allowable size of the fine particles employed for planarization. This 10 times difference in size permits readily distinguishable texture that is unrelated to roughness produced by the planarization process.

A wide variety of texturing abrasive materials may be successfully employed. These include, but arc not limited to, SiO₂, Al₂O₃, SiC, SiN, diamond, and combinations comprising at least one of the foregoing,

The improvement in forming a PCB can also result from the planarization-surface being in random, pseudo random or prescribed (or otherwise predetermined) physical contact with the PCB substrate, under sufficient pressure so that the PCB substrate, once planarized, is essentially uniform throughout the entire surface of interest. For example, an improved PCB substrate is achieved when a planarization surface is placed in contact with a PCB substrate so as to sweep out a path which is a combination of circular, horizontal and vertical motions over a portion of the PCB substrate, as opposed to a single dimensional path (e.g., only a vertical path). The end result is a more uniform planarized PCB substrate from a more uniformly worn planarizing surface.

The planarizing liquid is typically supplied to the substrate and/or the planarization surface by continuously pumping, or alternatively intermittently pumping, the material onto the substrate to be planarized, the planarization surface, or both. Given the amount of material that is to be removed in PCB substrate planarization, an additional improvement is obtained when the planarizing liquid is supplied to the planarizing surface in various flow rates and combinations.

Since removal rate is proportional to the concentration of fine particles in the planarizing liquid, it may be desirable to supply two streams of liquid to the substrate surface, the first containing little or no particulate material and the second containing a high concentration of fine particles. The removal rate during planarization will be a function of the relative flow rates of the two streams. Thus, if a high initial removal rate is desired, the ratio of flows of particle-rich to particle-free streams will be high. Towards the end of the process where control, not rate, is most important, the flow ratios may then be reversed to slow down removal. In another embodiment, the abrasive component may comprise bimodal or multimodal particle size distribution, wherein a plurality of abrasive particle groupings is each characterized by an average particle size. Preferably the average particle size of a first grouping is 2 to 100 times larger than an average particle size of a second grouping. Various other schemes of adjusting composition and flow may be selected to specific purposes by those skilled in the art while staying within the scope of the present invention.

An important consideration with respect to various electronic circuits is the availability and thus the cost at which the circuits can routinely be produced, which are often closely related to the number of required process steps. Elimination of only a single step, when multiplied by the vast number of PCBs produced annually, results in a distinct improvement in time and utilization of resources over that known in the art. Such an unobvious benefit has been discovered wherein a PCB substrate is planarizcd on both sides, either simultaneously, or essentially simultaneously during a single pass through an apparatus, thus reducing the number of production steps.

This improved method includes a PCB substrate being brought into physical contact with at least one planarizing surface on each side, along with a planarizing liquid supplied to each of the two or more sides. As described above, the planarizing-surface is in constant motion under suitable pressure biased against and in contact with the sides of the PCB substrate. Preferably, the planarizing surfaces are in a random, pseudo-random or prescribed motion over the area to be planarized, more preferably in motion such that the opposing planarizing-surfaces are in synchronized motion to provide an essentially planarized PCB substrate having an adequate texture as described above. In one embodiment, for example, a pair of planarizing surfaces may be disposed such that a PCB substrate is located in between them, while in physical contact with each one of the sides of the PCB substrate located opposite to one another. The random motion of the planarizing surfaces is thus preferably synchronized on both surfaces such that the location of the planarizing surfaces relative to each other remains constant, while the location of the planarizing surfaces relative to the PCB substrate is ever-changing. In another embodiment, the planarizing surfaces are in the form of cylindrical rollers disposed such that the PCB substrate is fed into the nip between the two rollers. The amount, composition, and delivery of the planarizing liquid, along with the rotational speed of the rollers and the pressure applied to the PCB substrate there between, are controlled to effectively planarize the PCB substrate as described above. The end result being a process having fewer steps (eg., a single step) as opposed to a two or more step processes requiring a first side of the PCB substrate to be planarized, followed by turning the substrate over to planarize a second side located opposite the first side.

In addition to the improved chemical-mechanical planarization as described herein, an additional aspect of providing an improved PCB substrate includes the combination of chemical-mechanical planarization with electrolytic etching. Specifically an electric potential is applied between a PCB substrate and a planarizing or polishing surface during chemical mechanical planarization. The planarizing liquid includes an electrolyte, a carrier, and an abrasive. The electrolyte and the carrier may or may not be the same (e.g., water, dissolved metal salts in water, sulfuric acid in water, and sodium chloride dissolved in water). The electrolyte thus completes the electric circuit between the anode and cathode of the electrolytic cell formed therein. The potential is applied to remove material from the PCB substrate by electrochemically dissolving the material. This process requires the PCB substrate to act as the anode in the electrochemical cell, wherein a reduction in charge (i.e., oxidation) converts the metal contained thereon into an electrolyte soluble ion, or an ionic salt, along with a corresponding anion present in the electrolyte. The electrical current can be constant, variable levels, pulsed or combinations thereof. The metal is thus removed from the anode and deposited onto a cathode. Depending on the composition of the electrolyte, the temperature, the pH, and the relative concentrations of the components, the removed metal or removed metal containing salt may be precipitated out of the electrolyte solution. In any event, the electrochemical potential is applied simultaneously, or essentially simultaneously with the chemical mechanical planarization, such that a planarizcd PCB is produced having an improved ability for an increased number of the connectors either before, or after the application of all the connectors required to be located on the PCB substrate,

While it is apparent that the invention herein disclosed is well calculated to achieve the desired results, it will be appreciated that numerous modifications and embodiments may be devised by those skilled in the art, and it is intended that the appended claims cover all such modifications and embodiments as fall within the true spirit and scope of the present invention. All patents and other documents cited herein are incorporated by reference herein.

## Claims

1. A method of preparing a printed circuit board substrate comprising:
contacting at least a portion of a surface of said printed circuit board substrate with a planarizing liquid, a planarizing surface, and an abrasive component to produce a surface texture on said printed circuit board surface, said texture having a roughness with a cross sectional area less than a cross sectional area of a smallest wiring feature in the layer or layers of said printed circuit board surface being prepared, wherein said planarizing liquid comprises a liquid carrier and optionally a component to remove material from said printed circuit board substrate, and wherein said contacting comprises a plurality of random, prescribed or combination thereof of contacting motions on said printed circuit board surface.

2. The method of claim 1, wherein said roughness has an average cross sectional area of 1 to 10 percent of said cross sectional area of said smallest wiring feature,

3. The method of claim 1, wherein said planarizing liquid is applied to said printed circuit board substrate, said planarizing surface, or both in discrete increments or continuously over time.

4. The method of claim 3, wherein said application of said discrete increments of said planarizing liquid comprises application of a plurality of planarizing liquids.

5. The method of claim 4, wherein said application of said plurality of planarizing liquids are applied in varying amounts.

6. The method of claim 3, wherein said roughness has an average cross sectional area of 1 to 10 percent of said cross sectional area of said smallest wiring feature.

7. The method of claim 3, wherein said abrasive component comprises a plurality of abrasive particle groupings, each grouping having an average particle size, wherein an average particle size of a first grouping is 2 to 100 times larger than an average particle size of a second grouping.

8. A method of preparing a printed circuit board substrate comprising:
contacting at least a portion of a first side of said printed circuit board substrate with a first planarizing liquid, a first planarizing surface, and an abrasive component to produce a surface texture on said first side, said first side texture having a roughness with a cross sectional area less than a cross sectional area of a smallest wiring feature on said first side while
contacting at least a portion of a second side of said printed circuit board substrate located opposite said first side with a second planarizing liquid, a second planarizing surface and an abrasive component to produce a texture on said second side, said second side texture having a roughness with a cross sectional area less than a cross sectional area of a smallest wiring feature on said second side, wherein each of said planarizing liquids comprises a liquid carrier and optionally a component to remove material from said each of said sides.

9. A method of preparing a printed circuit board substrate comprising:
contacting at least a portion of a surface of said printed circuit board substrate with a planarizing liquid comprising an electrolyte, a planarizing surface, and an abrasive component;
applying an electric current to said planarizing surface and said printed circuit board substrate through said liquid electrolyte to produce a surface texture on said printed circuit board surface, said texture having a roughness with a cross sectional area less than a cross sectional area of a smallest wiring feature on said printed circuit board surface, wherein said planarizing liquid comprises a liquid carrier, and optionally a component to remove material from said circuit board substrate.

10. The method of claim 9, wherein said electric current is applied in discrete pulses over time
